# EUROPEAN PATENT APPLICATION

(11) **EP 4 227 427 A1**
(43) Date of publication of application: **16.08.2023**
(21) Application number: 21877428.9
(22) Date of filing: 29.09.2021
(51) Int. Cl.: C22C 9/06, C22C 27/02, H01B 12/10, H01F 6/06

(54) **NBTI SUPERCONDUCTING MULTI-CORE WIRE**

(30) Priority: 08.10.2020 JP 2020170630
(71) Applicant: FURUKAWA ELECTRIC CO., LTD., Chiyoda-ku Tokyo 100-8322 (JP)
(72) Inventor: SUGIMOTO, Masahiro, Tokyo 100-8322 (JP); KATAYAMA, Kota, Tokyo 100-8322 (JP); II, Hideki, Tokyo 100-8322 (JP); KATO, Tomoya, Tokyo 100-8322 (JP)
(74) Representative: Winter, Brandl - Partnerschaft mbB
(86) International application number: PCT/JP2021/035746
(87) International publication number: WO 2022/075127

(57) **Abstract**

A NbTi superconducting multicore wire includes:
a core portion;
a first barrier layer arranged around the circumference of the core portion and composed of a first copper alloy including at least one element selected from Ni or Mn;
a filament assembly arranged around the circumference of the first barrier layer and including a plurality of NbTi filament assemblies each including a plurality of NbTi filaments, the plurality of NbTi filaments being at least seven NbTi filaments, embedded in a matrix composed of a second copper alloy including at least one element selected from Ni or Mn;
a second barrier layer arranged around the circumference of the filament assembly and composed of the first copper alloy; and
a stabilizing layer arranged around the circumference of the second barrier layer and composed of a metal,
in a transverse cross section perpendicular to a longer direction, the plurality of NbTi filaments in each of the NbTi filament assemblies being arranged in one or more circular shapes each having a different diameter, centering on one NbTi filament; and a plurality of NbTi filaments arranged in a circular shape in an outermost circle being arranged at approximately equal intervals along a circumferential direction.

## Description

### TECHNICAL FIELD

The present disclosure relates to a NbTi superconducting multicore wire.

### BACKGROUND ART

In general, a NbTi superconducting wire is composed of a plurality of NbTi filaments and a stabilizing metal in which the plurality of NbTi filaments are embedded. Further, the NbTi superconducting wire may be formed into a twisted wire structure in order to increase conduction current capacity, and to improve current density, mechanical stability, and wire-winding workability. When a strand or twisted wire of a NbTi superconducting wire is used under a changing magnetic field, an alternating current (AC) loss occurs, this causing a decrease in cooling efficiency. As the AC loss at this time, in addition to a hysteresis loss generated in a NbTi filament portion and a coupling loss (including an eddy current loss) generated in a stabilizing metal portion formed of a normal conducting metal, there is an inter-strand coupling loss due to currents flowing between superconducting strands.

Usually, the hysteresis loss in the NbTi filament portion can be suppressed by reducing a filament diameter, but production costs increase as the filament diameter decreases. Therefore, it is conventional to design a filament diameter value to be as large as possible within a range of levels such that the diameter can satisfy required characteristics of the equipment. On the other hand, the coupling loss in the stabilizing metal portion can be reduced by disposing a copper alloy having large electric resistance, such as a CuNi alloy, around the circumference of individual filaments, between filaments, or around the circumference of the strand. In particular, the coupling loss can be further reduced by disposing a copper alloy, such as a CuNi alloy, all over spaces around the circumference of filaments, those between filaments, and those around the circumference of the strand. Further, by shortening a twist pitch of the filaments, the coupling loss can be reduced.

Based on this idea, as an AC wire which is generally used in a commercial frequency ranging from 1 T to 2 T or less of an empirical magnetic field, a NbTi superconducting wire having a structure in which a stabilizing metal portion is completely eliminated and a matrix portion thereof is entirely formed of a CuNi alloy is used. In the AC wire having such a configuration, critical current density Jc in a low magnetic field is extremely high, and a loss due to magnetic field variation is large, so that stability is insufficient. For this reason, in the AC wire, stability in a low magnetic field is improved by making the wire diameter as thin as possible to improve heat discharge, or by installing stabilizing copper which is finely partitioned by CuNi alloy barrier layers, in the central portion of the wire.

However, in such an AC wire, the diameter of the NbTi filament is reduced to about 0.1 to 0.5 um in order to reduce a hysteresis loss and improve stability, and therefore Jc in the magnetic field is small and the critical current capacity per strand is small. Thus, when the AC wire is used for a large-current wire, strands of AC wires should be twisted multiple times.

On the other hand, a NbTi wire for pulse used in a high magnetic field side of 2T or more is used for instruments such as a generator coil, a superconductive power storage device (SMES), a magnet for theoretical research used in an elementary particle accelerator, a nuclear fusion laboratory, and the like. Such a NbTi wire for pulse has a twisted wire structure because a large current capacity of several kA to more than 10 kA is required in a high magnetic field region near 5 T, and the number of twisted wires is preferably small in order to increase mechanical rigidity of the wire for pulse.

Therefore, the wire for pulse needs to have increased critical current capacity per strand, and the outer diameter of the strand is naturally increased. As the outer diameter of the strand increases, heat discharge becomes poor. For this reason, it is not possible to employ, for the wire for pulse, the configuration of AC wires in which a matrix portion thereof is entirely formed of a CuNi alloy. In other words, when the wire for pulse is used in a large-sized device, quench of strands results in a serious accident. Thus, an amount of the stabilizing metal in a material for embedding the NbTi filaments should be increased for stabilization.

Further, although the wire for pulse experiences a smaller rate of change in the magnetic field than the AC wire, it is essential to reduce an AC loss in order to suppress a decrease in the cooling efficiency and improve instability caused by generation of heat due to the AC loss.

As a conventional superconducting wire for pulse, for the purpose of ensuring stability and reducing an AC loss, a wire having a three-layer structure in which NbTi filaments covered with copper and a stabilizing material formed of a CuNi alloy are embedded in a copper matrix is used. However, as copper is present between NbTi filaments and deformation resistance of copper is smaller than that of NbTi or CuNi, a deformation state differs between NbTi or CuNi and copper during hot extrusion or wire drawing, which causes deformation of the filament shape or breaking of the filament in some cases. Furthermore, as copper outside the NbTi filament generally is thin, Ni in CuNi diffuses into Cu due to a heat treatment in the wire production process, and thereby the electric resistance of copper around the filament increases. Such an increase in the electric resistance suppresses a phenomenon that the filaments are electromagnetically coupled due to an external changing magnetic field, but lowers function as a stabilizing material.

As described above, when the NbTi superconducting multicore wire is used under a changing magnetic field, an AC loss including a hysteresis loss independent of a magnetic field change speed and a coupling loss (including eddy current loss) that increases depending on a magnetic field change speed is generated. In order to decrease the hysteresis loss, it is effective to decrease a diameter of the NbTi filament. In order to reduce the coupling loss, it is effective to shorten a twist pitch of the filament and to increase electric resistance between the filaments, and the like.

If the filament diameter is too small, extraordinary deformation of the filament occurs, and a practical current conducting characteristic near 5 T is lowered (current density per NbTi decreases), and it is therefore common practice to design the filament diameter to have a size of about 3 to 10 um. Further, if the twist pitch of the filament is too small relative to the strand diameter, the current conducting characteristics are similarly lowered, and wire breaking is likely to occur. Thus, the twist pitch length is often set to about 10 times the strand diameter. In order to increase electric resistance between the filaments, it is effective to composite a copper alloy (Cu-Ni-Mn alloy or Cu-Si-Mn alloy), to which elements such as Ni, Mn, and Si have been added, with a NbTi filament.

A diameter of the superconducting multicore wire is appropriately selected to ensure an efficient critical current value depending on the type of the superconducting equipment. From the viewpoint of coil productivity, the diameter of the superconducting wire is often set to around 1 mm, and, however, when the filament diameter of 6 um or less is produced by a single stack billet (a method of producing a multicore wire by one billet stacking), the number of stacked strands is too large. Thus, not only the number of work steps is increased but also contamination of foreign matters or bonding defects caused by an increase in bonding area between the stacked primary strands are likely to occur, which results in frequent wire breaking (a defect in which the whole strand breaks) during wire drawing. Therefore, when a filament diameter of about 3 um is required, a double stack method is generally used.

However, in a conventional double stack method, there is a problem that abnormal deformation of the filament in a sub-bundle occurs, and this not only degrades the current carrying characteristics, but also easily causes wire breaking during wire drawing. An attempt was made to decrease the hysteresis loss and to prevent the current carrying characteristics from declining by disposing a copper alloy such as Cu-0.5 wt% Mn or Cu-5 wt% Ni, which had a relatively low concentration of an additive element, around the filament to improve filament processability and reduce the filament diameter to about 3 um. The attempt, however, did not reach a solution of further problems that a decrease in the coupling loss and a decrease in the production costs are both satisfied.

For example, Patent Document 1 discloses a superconducting composite billet formed by boring a plurality of vertical holes in a billet having a circular cross section and being formed of copper or a copper alloy, and filling the vertical holes with a superconducting material. The superconducting composite billet includes one vertical hole in a central portion, and includes a plurality of vertical holes arranged on two concentric circles at equal intervals, each of the two concentric circles having the center at the center of the billet. Any center line passing through the center of the billet has a length of 3.4 p (p is an inner diameter of the vertical hole) or less. However, the Patent Document 1 has improvement in only the superconducting characteristics due to a good shape of the superconducting filament. It was not possible to obtain a NbTi superconducting multicore wire that has excellent productivity and that is required to have a low AC loss characteristic.

Non-Patent Documents 1 and 2 disclose a structure of a NbTi wire for pulse developed for generators. A single-stack type three-layer structural line is applied in order to obtain a good filament shape. However, since the strand diameter was reduced to about 0.5 to 0.6 mm in order to obtain a filament diameter of about 3 um, the current value per strand was too small, and there was a problem of productivity that it was unavoidable to employ a double-molded twisted wire structure.

In Non-Patent Document 3, NbTi filaments having a thickness of about 3 um were obtained by a double stack method using Cu-0.5 wt% Mn as a matrix. However, some superconducting filaments had significantly abnormal shapes, and there was a concern about problems in the production such as wire breaking during wire drawing.

Patent Document 1: Japanese Patent No.3445307

Non-Patent Document 1: IEEJ Transactions on Power and Energy, Vol. 111, No. 4, 1991, pp. 366-373
Non-Patent Document 2: Magnet Technology (MT-11), Proceedings (1989) pp. 1027-1032
Non-Patent Document 3: IEEE Transactions on Applied Superconductivity, Vol. 25, No. 3, (2015) 6001405

### DISCLOSURE OF THE INVENTION

### Problems to be Solved by the Invention

An object of the present disclosure is to provide a NbTi superconducting multicore wire, which can achieve low production costs, a low AC loss and a high critical current. Means for Solving the Problems

A first aspect of the present disclosure relates to a NbTi superconducting multicore wire, including: a core portion; a first barrier layer arranged around the circumference of the core portion and composed of a first copper alloy including at least one element selected from Ni or Mn; a filament assembly arranged around the circumference of the first barrier layer and including a plurality of NbTi filament assemblies each including a plurality of NbTi filaments, the plurality of NbTi filaments being at least seven NbTi filaments, embedded in a matrix composed of a second copper alloy including at least one element selected from Ni or Mn; a second barrier layer arranged around the circumference of the filament assembly and composed of the first copper alloy; and a stabilizing layer arranged around the circumference of the second barrier layer and composed of a metal, in a transverse cross section perpendicular to a longer direction, the plurality of NbTi filaments in each of the NbTi filament assemblies being arranged in one or more circular shapes each having a different diameter, centering on one NbTi filament, and a plurality of NbTi filaments arranged in a circular shape in an outermost circle being arranged at approximately equal intervals along the circumferential direction.

A second aspect of the present disclosure relates to the NbTi superconducting multicore wire as described in the first aspect, in which a total ratio A (X_{Ni}A + X_{Mn}A), which is a sum of a Ni content ratio X_{Ni}A and a Mn content ratio X_{Mn}A in the second copper alloy constituting the matrix of the filament assembly, is smaller than a total ratio B (X_{Ni}B + X_{Mn}B), which is a sum of a Ni content ratio X_{Ni}B and a Mn content ratio X_{Mn}B in the first copper alloy constituting the first barrier layer and the second barrier layer.

A third aspect of the present disclosure relates to the NbTi superconducting multicore wire as described in the first or second aspect, in which, in the transverse cross section, the plurality of NbTi filaments in each of the NbTi filament assemblies are arranged in two or more circular shapes each having a different diameter, centering on the one NbTi filament, and the plurality of NbTi filaments arranged in a circular shape in the outermost circle are arranged so as to rotate by approximately (180/n)° centering on the one NbTi filament arranged at the center, relative to a base line L, the base line L connecting: a center of a NbTi filament among a plurality of NbTi filaments which are internally adjacent with the plurality of NbTi filaments arranged in a circular shape in the outermost circle, and which are arranged in a circular shape; and a center of the one NbTi filament arranged at the center.

A fourth aspect of the present disclosure relates to the NbTi superconducting multicore wire as described in any one of the first to third aspects, in which the core portion includes a matrix composed of the first copper alloy.

A fifth aspect of the present disclosure relates to the NbTi superconducting multicore wire as described in any one of the first to fourth aspects, in which the Ni content ratio X_{Ni}B in the first copper alloy constituting the first barrier layer and the second barrier layer is 5.0% by mass or more and 30.0% by mass or less, and the Ni content ratio X_{Ni}A in the second copper alloy constituting the matrix of the filament assembly is 0.1X_{Ni}B or more and 0.9X_{Ni}B or less.

A sixth aspect of the present disclosure relates to the NbTi superconducting multicore wire as described in any one of the first to fifth aspects, in which the Mn content ratio X_{Mn}B in the first copper alloy constituting the first barrier layer and the second barrier layer is 0.1% by mass or more and 2.0% by mass or less, and the Mn content ratio X_{Mn}A in the second copper alloy constituting the matrix of the filament assembly is 0.3X_{Mn}B or more and 0.9X_{Mn}B or less.

A seventh aspect of the present disclosure relates to the NbTi superconducting multicore wire as described in any one of the first to sixth aspects, in which, in the transverse cross section, a ratio (cross sectional area of the matrix/total cross sectional area of the plurality of NbTi filaments) of a cross sectional area of the matrix in the filament assembly with respect to a total cross sectional area of the plurality of NbTi filaments is 0.2 or more and 2.0 or less, and a ratio {(cross sectional area of the matrix + cross sectional area of the first barrier layer + cross sectional area of the second barrier layer + cross sectional area of the matrix in the core portion + cross sectional area of the stabilizing layer) / total cross sectional area of the plurality of NbTi filaments} of a total of cross sectional areas of the matrix in the filament assembly, the first barrier layer, the second barrier layer, the matrix in the core portion, and the stabilizing layer, with respect to a total of cross sectional area of the plurality of NbTi filaments is 2.0 or more and 6.0 or less.

### Effects of the Invention

According to the present disclosure, it is possible to provide a NbTi superconducting multicore wire that can achieve low production costs, a low AC loss and a high critical current.

### BRIEF DESCRIPTION OF THE DRAWINGS

FIG. 1 is a transverse cross sectional view showing an example of a NbTi superconducting multicore wire of an embodiment;
FIG. 2 is an enlarged cross sectional view showing an example of a filament assembly which constitutes the NbTi superconducting multicore wire of the embodiment;
FIG. 3 is an enlarged cross sectional view showing an example of a NbTi filament assembly which constitutes the filament assembly of FIG. 2;
FIG. 4 is an enlarged cross sectional view showing another example of the filament assembly which constitutes the NbTi superconducting multicore wire of the embodiment; and
FIG. 5 is an enlarged cross sectional view showing an example of the NbTi filament assembly which constitutes the filament assembly of FIG. 4.

### PREFERRED MODE FOR CARRYING OUT THE INVENTION

Below, detailed description will be given based on embodiments.

The NbTi superconducting multicore wire according to an embodiment includes: a core portion; a first barrier layer arranged around the circumference of the core portion and composed of a first copper alloy including at least one element selected from Ni or Mn; a filament assembly arranged around the circumference of the first barrier layer and including a plurality of NbTi filament assemblies each including a plurality of NbTi filaments, the plurality of NbTi filaments being at least seven NbTi filaments, embedded in a matrix composed of a second copper alloy including at least one element selected from Ni or Mn; a second barrier layer arranged around the circumference of the filament assembly and composed of the first copper alloy; and a stabilizing layer arranged around the circumference of the second barrier layer and composed of a metal. In the transverse cross section perpendicular to a longer direction, the plurality of NbTi filaments in each of the NbTi filament assemblies are arranged in one or more circular shapes each having a different diameter, centering on one NbTi filament, and a plurality of NbTi filaments arranged in a circular shape in an outermost circle are arranged at approximately equal intervals along a circumferential direction.

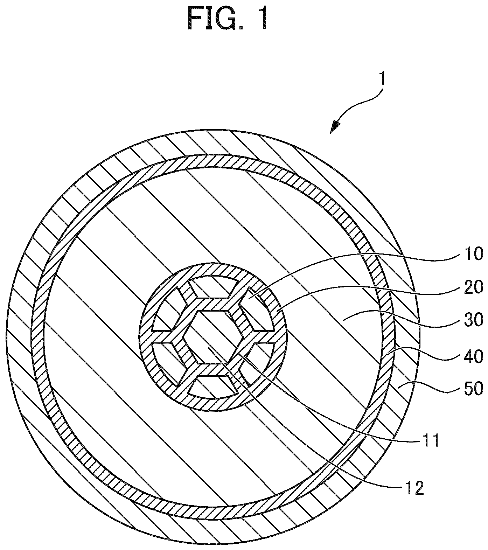

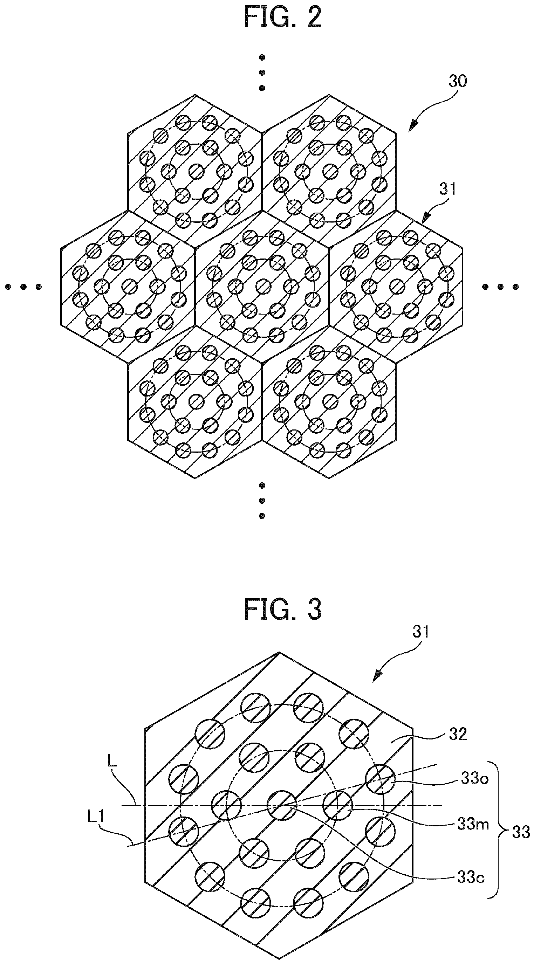

FIG. 1 is a drawing showing an example of a transverse cross section of a NbTi superconducting multicore wire of an embodiment. FIG. 2 is an enlarged sectional view showing an example of a filament assembly which constitutes the NbTi superconducting multicore wire. FIG. 3 is an enlarged sectional view showing an example of a NbTi filament assembly which constitutes the filament assembly of FIG. 2. In FIGs. 2 and 3, imaginary circles each linking a plurality of NbTi filaments 33 arranged in a circular shape in respective layers of a NbTi filament assembly 31 are shown by two-dot chain line.

As illustrated in FIGs. 1 to 3, the NbTi superconducting multicore wire 1 of the embodiment includes a core portion 10, a first barrier layer 20 arranged around the circumference of the core portion 10, a filament assembly 30 arranged around the circumference of the first barrier layer 20, a second barrier layer 40 arranged around the circumference of the filament assembly 30, and a stabilizing layer 50 arranged around the circumference of the second barrier layer 40.

In the transverse cross section perpendicular to the longer direction of the NbTi superconducting multicore wire 1 shown in FIG. 1, the first barrier layer 20 is annular and covers the entire circumference of the core portion 10. The first barrier layer 20 is composed of a first copper alloy including at least one element selected from Ni or Mn. The first copper alloy which constitutes the first barrier layer 20 may include Si.

The filament assembly 30 is annular in the transverse cross section of the NbTi superconducting multicore wire 1 and covers the entire circumference of the first barrier layer 20. As shown in FIG. 2, the filament assembly 30 includes a plurality of NbTi filament assemblies 31.

As shown in FIGs. 2 and 3, each of the NbTi filament assemblies 31 includes a matrix 32 and a plurality of NbTi filaments 33, the plurality of NbTi filaments 33 being at least seven NbTi filaments.

The matrix 32 of the NbTi filament assembly 31 is composed of a second copper alloy including at least one element selected from Ni or Mn. The second copper alloy which constitutes the matrix 32 may include Si.

The plurality of NbTi filaments 33 are embedded in the matrix 32. The NbTi filaments 33 embedded in the matrix 32 are arranged separately from each other, so that they are not in contact with each other.

As shown in FIG. 1, the second barrier layer 40 is annular in the transverse cross section of the NbTi superconducting multicore wire 1 and covers the entire circumference of the filament assembly 30. The second barrier layer 40 is composed of the first copper alloy including at least one element selected from Ni or Mn. The first copper alloy which constitutes the second barrier layer 40 may include Si. The alloy composition of the first copper alloy which constitutes the first barrier layer 20 and the second barrier layer 40 differs from the alloy composition of the second copper alloy which constitutes the matrix 32 of the filament assembly 30.

The stabilizing layer 50 is annular in the transverse cross section of the NbTi superconducting multicore wire 1 and covers the entire circumference of the second barrier layer 40. The stabilizing layer 50 is composed of metal. For example, the stabilizing layer 50 and the core portion 10 are composed of the same copper alloy.

As shown in FIGs. 2 and 3, in the transverse cross section of the NbTi superconducting multicore wire 1, a plurality of NbTi filaments 33 embedded in the matrix 32 of each of the NbTi filament assemblies 31 are arranged in one or more circular shapes each having a different diameter, centering on one NbTi filament 33 (central filament 33c), and a plurality of NbTi filaments 33 arranged in a circular shape in the outermost circle are arranged at approximately equal intervals along the circumferential direction.

Herein, as shown in FIG. 3, as an example of the configuration of the NbTi filaments 33 embedded in the NbTi filament assembly 31, as the first layer, six NbTi filaments 33m (inner filaments) are arranged in a circular shape around the NbTi filament 33c, and as the second layer, twelve NbTi filaments 33o (outermost layer filaments) are arranged in a circular shape around the circumference of an imaginary circle formed of the six NbTi filaments 33m. That is, in the transverse cross section of the NbTi superconducting multicore wire 1, the NbTi filament 33c (central filament) is a filament arranged at the center of the plurality of NbTi filaments 33; the NbTi filaments 33m (inner filaments) are, among the plurality of NbTi filaments 33, a plurality of filaments arranged in a circular shape in from the first layer to the inner layer of the outermost layer; and the NbTi filaments 33o (outermost layer filaments) are, among the plurality of NbTi filaments 33, a plurality of filaments arranged in a circular shape in the outermost layer.

Both the center of the imaginary circle which links six NbTi filaments 33m constituting the first layer and the center of the imaginary circle which links twelve NbTi filaments 33o constituting the second layer are the NbTi filament 33c. The diameter of the imaginary circle which links the six NbTi filaments 33m constituting the first layer is smaller than the diameter of the imaginary circle which links twelve NbTi filaments 33o constituting the second layer. That is, the six NbTi filaments 33m which constitute the first layer and the twelve NbTi filaments 33o which constitute the second layer are arranged in a concentric circular shape, centering on the NbTi filament 33c.

The plurality of NbTi filaments 33 which constitute the outermost circle, which are the twelve NbTi filaments 33m which constitute the second layer here, are arranged at approximately equal intervals along the circumferential direction of the imaginary circle which links the twelve NbTi filaments 33m constituting the second layer.

When the NbTi filament assembly 31 includes NbTi filaments 33 arranged only in one layer, for example, when the six NbTi filaments 33o which constitute one layer are arranged in a circular shape around the NbTi filament 33c, the six NbTi filaments 33o which constitute the outermost circle are arranged at approximately equal intervals along the circumferential direction of the imaginary circle which links the six NbTi filaments 33o constituting the one layer. That is, when the NbTi filament assembly 31 includes NbTi filaments 33 arranged only in one layer, the configuration of the NbTi filaments 33m (inner filaments 33m) is excluded from the plurality of NbTi filaments 33.

When the plurality of NbTi filaments 33 in each of the NbTi filament assemblies 31 are arranged in a circular shape centering on the NbTi filament 33c, and the plurality of NbTi filaments 33o arranged in a circular shape in the outermost circle are arranged at approximately equal intervals along the circumferential direction in the transverse cross section of the NbTi superconducting multicore wire 1, filament processability is good. As a result, the NbTi superconducting multicore wire 1 decreases production costs and achieves low AC losses such as a low hysteresis loss or a low coupling loss and a high critical current.

A situation in which the plurality of NbTi filaments arranged in a circular shape in the outermost circle are arranged at approximately equal intervals along the circumferential direction refers to a situation in which difference in the plurality of intervals between adjacent NbTi filaments along the circumferential direction is within ±10%, preferably ±5%, more preferably ±3%, and the most preferably 0%, that is, all of the intervals between adjacent NbTi filaments are the same. As the difference in the plurality of intervals between adjacent NbTi filaments is smaller than ±10%, characteristics of the NbTi filament become better. This further improves in a low AC loss and high critical current, and suppresses breaking of the NbTi superconducting multicore wire due to breaking of the NbTi filaments, this resulting in further reduction in production costs.

A situation in which, in the transverse cross section of the NbTi superconducting multicore wire 1, the plurality of NbTi filaments 33 are arranged in a circular shape, centering on the NbTi filament 33c refers to that flakiness (= (long radius - short radius)/long radius) of a circle formed by linking the centers of the plurality of NbTi filaments 33 arranged in each of the layers is preferably 0.3 or less, more preferably 0.1 or less, and the most preferably 0. When the flakiness of the circle formed by linking the centers of the plurality of NbTi filaments 33 arranged in each of the layers is 0.3 or less, it is possible to suppress abnormal deformation of the filaments arranged in the outermost circle, the abnormal deformation occurring while processing final strands obtained by assembling the plurality of NbTi filaments 33. This decreases the AC loss of the NbTi superconducting multicore wire 1, resulting in high current carrying stability and further improvement in high critical current density.

Additionally, a total ratio A (X_{Ni}A + X_{Mn}A), which is a sum of a Ni content ratio X_{Ni}A and a Mn content ratio X_{Mn}A in the second copper alloy constituting the matrix 32 of the filament assembly 30, is preferably smaller than a total ratio B (X_{Ni}B + X_{Mn}B), which is a sum of a Ni content ratio X_{Ni}B and a Mn content ratio X_{Mn}B in the first copper alloy constituting the first barrier layer 20 and the second barrier layer 40.

Ni and Mn in the second copper alloy constituting the matrix 32 and Ni and Mn in the first copper alloy constituting the first barrier layer 20 and the second barrier layer 40 have a function of suppressing an increase in the hysteresis loss caused by an increase in an equivalent filament diameter of the NbTi filament 33 due to inter-filament coupling (proximity effect) by infiltrating superconducting electrons into the matrix 32 between plurality of NbTi filaments 33, and have a function of increasing equivalent lateral resistance to reduce a coupling loss between filaments. Further, as the contents of Ni and Mn in the matrix 32 increase, good filament processability decreases. On the other hand, Ni and Mn in the first barrier layer 20 and the second barrier layer 40 have little influence on the processability of the NbTi filaments 33. Therefore, by making the Ni and Mn contents in the first barrier layer 20 and the second barrier layer 40 larger than that in the second copper alloy constituting the matrix 32, it is possible to increase the equivalent lateral resistance and proactively reduce the AC loss of the NbTi superconducting multicore wire 1.

As described above, when the total ratio A (X_{Ni}A + X_{Mn}A) in the matrix 32 of the filament assembly 30 is made smaller than the total ratio B (X_{Ni}B + X_{Mn}B) in the first barrier layer 20 and the second barrier layer 40, element component ratios of Ni and Mn that contribute to electric resistance and strength of the matrix 32 embedding the plurality of NbTi filaments 33 are smaller than the element component ratios of Ni and Mn in the first barrier layer 20 and the second barrier layer 40. Therefore, the filament assembly 30 has excellent processability and the first barrier layer 20 and the second barrier layer 40 have higher resistance than the matrix 32 of the filament assembly 30 to increase the equivalent lateral resistance, which makes it possible to more quickly attenuate the coupling current between filaments excited by an external changing magnetic field in the filament assembly 30. As a result, the low AC loss of the NbTi superconducting multicore wire 1 can be further improved.

In the transverse cross section of the NbTi superconducting multicore wire 1, it is preferable that the plurality of NbTi filaments 33 in each of the NbTi filament assemblies 31 are arranged in two or more circular shapes each having a different diameter, centering on one NbTi filament 33c, and the plurality of NbTi filaments 33o arranged in a circular shape in the outermost circle are arranged so as to rotate by approximately (180/n)° centering on the NbTi filament 33c arranged at the center, relative to a base line L. The base line L connects a center of a NbTi filament among a plurality of NbTi filaments 33m which are internally adjacent with the plurality of NbTi filaments 33o arranged in a circular shape in the outermost circle and which are arranged in a circular shape, and a center of the NbTi filament 33c arranged at the center. The centers of the plurality of NbTi filaments 33o arranged in a layer of the outermost circle are not arranged on the base line L. n is the number of NbTi filaments 33o arranged in a layer of the outermost circle. In the case of one layer, n is preferably 6, in the case of two layers, n is preferably 12, in the case of three and four layers, n is preferably 18, and in the case of five layers, n is preferably 24.

As described above, by providing two or more layers of the plurality of NbTi filaments 33, and arranging the plurality of NbTi filaments 33o arranged in a circular shape in the outermost layer so as to rotate by approximately (180/n)° (line L1 which has rotated by approximately (180/n)° from the base line L) centering on the NbTi filament 33c, relative to the base line L defined by the plurality of NbTi filaments 33m internally adjacent and the NbTi filament 33c arranged at the center, it is possible to suppress abnormal deformation of filaments in the outermost circle, the abnormal deformation occurring while processing final strands including an assemble of the plurality of NbTi filaments 33. In particular, the effect is significant for the NbTi filaments 33o arranged in the layer of the outermost circle. As a result, the high current carrying stability and the high critical current density of the NbTi superconducting multicore wire 1 are further improved.

A situation in which the plurality of NbTi filaments 33o are arranged so as to rotate by approximately (180 /n)° around the NbTi filament 33c means that the NbTi filaments 33o are arranged so as to rotate by preferably the range of (180 /n)° ± 24/n°, more preferably the range of (180 /n)° ± 12 /n°, and most preferably (180 /n)°. When the NbTi filaments 33o are arranged so as to rotate by the range of (180 /n)° ± 24/n°, it is possible to suppress abnormal deformation of the filaments in the outermost circle, the abnormal deformation occurring during processing of end strands in which the plurality of NbTi filaments 33 are assembled, and thereby the AC loss of the NbTi superconducting multicore wire 1 is reduced, and high current carrying stability and high critical current density are further improved.

The core portion 10 preferably includes a matrix 11 (core portion matrix) composed of the first copper alloy. In this case, the copper alloy constituting the matrix 11 of the core portion 10 is the same as the copper alloy constituting the first barrier layer 20 and the copper alloy constituting the second barrier layer 40. In such a configuration, since lateral resistance of the core portion 10 increases, the coupling loss generated in the core portion 10 can be reduced.

As shown in FIG. 1, the core portion 10 may include a matrix 11 composed of the first copper alloy and a plurality of core portion stabilizing layers 12 embedded in the matrix 11. For example, the plurality of core portion stabilizing layers 12 are arranged in a circular shape around one core portion stabilizing layer 12. When the core portion 10 includes the matrix 11 and the core portion stabilizing layer 12, the coupling loss and eddy current loss generated in the core portion 10 can be reduced.

The Ni content ratio X_{Ni}B in the first copper alloy constituting the first barrier layer 20 and the second barrier layer 40 is preferably 5.0% by mass or more and 30.0% by mass or less, and the Ni content ratio X_{Ni}A in the second copper alloy constituting the matrix 32 of the filament assembly 30 is preferably 0.1X_{Ni}B or more and 0.9X_{Ni}B or less.

By setting the Ni content ratios within the above ranges, it is possible to further suppress an increase in the hysteresis loss due to the proximity effect between the NbTi filaments 33 and to further suppress an increase in the coupling loss due to a decrease in the lateral resistance of the NbTi filament assembly 31.

The Mn content ratio X_{Mn}B in the first copper alloy constituting the first barrier layer 20 and the second barrier layer 40 is 0.1% by mass or more and 2.0% by mass or less, and the Mn content ratio X_{Mn}A in the second copper alloy constituting the matrix 32 of the filament assembly 30 is 0.3X_{Mn}B or more and 0.9X_{Mn}B or less.

By setting the Mn content ratios within the above range, it is possible to further suppress an increase in the hysteresis loss due to the proximity effect between the NbTi filaments 33 and to further suppress an increase in the coupling loss due to a decrease in the lateral resistance of the NbTi filament assembly 31.

It is preferable that, in the transverse cross section of the NbTi superconducting multicore wire 1, a ratio (cross sectional area of the matrix 32/total cross sectional area of the plurality of NbTi filaments 33) of a cross sectional area of the matrix 32 in the filament assembly 30 with respect to a total cross sectional area of the plurality of NbTi filaments 33 in the filament assembly 30 is 0.2 or more and 2.0 or less, and a ratio {(cross sectional area of the matrix 32 + cross sectional area of the first barrier layer 20 + cross sectional area of the second barrier layer 40 + cross sectional area of the matrix 11 in the core portion 10 + cross sectional area of the stabilizing layer 50) / total cross sectional area of the plurality of NbTi filaments 33} of a total of cross sectional areas of the matrix 32 in the filament assembly 30, the first barrier layer 20, the second barrier layer 40, the matrix 11 in the core portion 10, and the stabilizing layer 50 with respect to a total of cross sectional area of the plurality of NbTi filaments 33 is 2.0 or more and 6.0 or less.

When the ratio of the cross sectional area of the matrix 32 relative to the total cross sectional area of the plurality of NbTi filaments 33 is 0.2 or more, it is possible to suppress current carrying instability due to an excessively large critical current density in the NbTi filament assembly 31. When the ratio is 2.0 or less, disturbance of the shape of the NbTi filaments 33 can be suppressed.

When the ratio of the total cross sectional areas of the matrix 32, the first barrier layer 20, the second barrier layer 40, the matrix 11 in the core portion 10, and the stabilizing layer 50 relative to the total cross sectional area of the plurality of NbTi filaments 33 is 2.0 or more, it is possible to suppress an increase in the AC loss and a decrease in current carrying stability. When the ratio is 6.0 or less, a decrease in the critical current density of the NbTi superconducting multicore wire 1 can be suppressed, and it becomes easy to design application instruments with high efficiency.

Although the NbTi filament assembly 31 in which six NbTi filaments 33m as the first layer are arranged around the NbTi filament 33c in a circular shape, and twelve NbTi filaments 33o as the second layer are arranged around an imaginary circle formed by the six NbTi filaments 33m in a circular shape is shown in FIG. 3, an arrangement configuration, such as an arranged number or an arrangement state, of the plurality of NbTi filaments 33 constituting the NbTi filament assembly 31 is not limited to the that of FIG. 3. From the viewpoint of low AC losses, high critical currents, and reduction in the production costs of the NbTi superconducting multicore wire 1, the NbTi filament assembly 31 preferably includes a plurality of NbTi filaments 33 having one or more and five or less layers around the NbTi filament 33c. When a plurality of NbTi filaments 33 are constituted by one layer, it is preferable that six NbTi filaments 33o are arranged in a circular shape in the first layer that is the outermost circle. When the plurality of NbTi filaments 33 are constituted by two layers, it is preferable that the same number of NbTi filaments 33m as described above, i.e., six NbTi filaments 33m, are arranged in a circular shape in the first layer, and twelve NbTi filaments 33o are arranged in a circular shape in the second layer that is the outermost circle. Similarly, when the plurality of NbTi filaments 33 are constituted by three or four layers, it is preferable that the same number of NbTi filaments 33m as those described above are arranged in a circular shape in the first and second layers, and eighteen NbTi filaments 33o are arranged in a circular shape in the third or fourth layer that is the outermost circle. When the plurality of NbTi filaments 33 are constituted by five layers, it is preferable that the same number of NbTi filaments 33m as those described above are arranged in a circular shape in the first to fourth layers, and twenty four NbTi filaments 33o are arranged in a circular shape in the fifth layer that is the outermost circle.

When the equivalent diameter of the NbTi superconducting multicore wire 1 is 0.7 mm or more and 2.0 mm or less and the equivalent diameter of the NbTi filament 33 is 2.0 µm or more and 6.0 µm or less, low AC losses, high critical currents, and reduction in production costs are further improved.

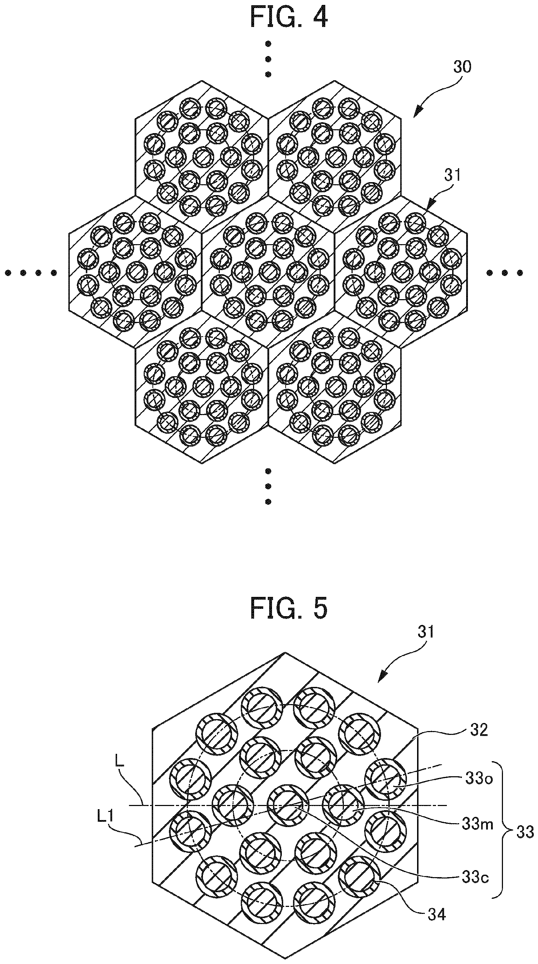

FIG. 4 is an enlarged cross sectional view showing another example of the filament assembly 30 constituting the NbTi superconducting multicore wire 1. FIG. 5 is an enlarged cross sectional view showing an example of the NbTi filament assembly 31 constituting the filament assembly 30 of FIG. 4.

As shown in FIGs. 4 and 5, the NbTi superconducting multicore wire 1 may further includes stabilizing Cu layers 34 each arranged around the circumference of each of the NbTi filaments 33. In the transverse cross section of the NbTi superconducting multicore wire 1, each of the stabilizing Cu layers 34 is annular and covers the entire circumference of each of the NbTi filament 33. By providing the stabilizing Cu layer 34 in the NbTi superconducting multicore wire 1, the current carrying stability of the NbTi superconducting multicore wire 1 is improved.

Next, an example of a method of producing the NbTi superconducting multicore wire 1 will be described.

Firstly, when the NbTi superconducting multicore wire 1 includes the stabilizing Cu layer 34, a NbTi rod is inserted into a copper tube to obtain a single core NbTi billet. Subsequently, the single core NbTi billet is subjected to hot extrusion and cold working to obtain an oxygen-free copper-coated NbTi single core wire.

Next, into all of through holes of a multi-hole tube which is formed of the second copper alloy and which has seven or more though-holes arranged in a predetermined arrangement state, when the NbTi superconducting multicore wire 1 has the stabilizing Cu layer 34, the oxygen-free copper-coated NbTi single core wires are inserted, and when the NbTi superconducting multicore wire 1 does not include the stabilizing Cu layers 34, NbTi rods are inserted, to obtain a primary composite billet. Subsequently, the primary composite billet is subjected to hot extrusion and cold working to obtain a rod-shaped primary strand as the NbTi filament assembly 31.

Next, a stabilizing rod-shaped body is obtained by coating the circumference of a rod-shaped copper hexagonal member as the core portion 10 with the first copper alloy as the first barrier layer 20. Subsequently, after the first copper alloy as the second barrier layer 40 is disposed on the inner surface of the copper tube as the stabilizing layer 50, a plurality of stabilizing rod-shaped bodies and a plurality of primary strands are inserted into the copper tube so as to have a predetermined arrangement configuration, thereby obtaining a secondary composite billet. Subsequently, the secondary composite billet is subjected to hot extrusion, and then heat treatment and cold working are repeated. Further, twisting and final drawing are performed to produce the NbTi superconducting multicore wire 1.

In the above-described method of producing the NbTi superconducting multicore wire 1, residual resistance ratios may change due to heating or processing curing, depending on the material constituting the NbTi superconducting multicore wire 1. Therefore, the residual resistance ratios at the time of use of the NbTi superconducting multicore wire 1 can be adjusted by appropriately annealing the NbTi superconducting multicore wire 1 in the intermediate step or the final step.

The transverse cross sectional shape of the NbTi superconducting multicore wire 1 thus obtained is not limited to a circular shape, but may be appropriately selected depending on the application, and for example, a rectangular shape is acceptable. When the transverse cross sectional shape of the NbTi superconducting multicore wire 1 is a rectangular shape, coil winding properties and current density can be improved.

Further, by bundling a plurality of NbTi superconducting multicore wires 1 into a twisted strand structure, current capacity can be increased according to the equipment to be applied. For example, a NbTi superconducting molded cable with increased current capacity can be obtained by subjecting the surface of the NbTi superconducting multicore wire 1 to a surface treatment such as metal plating, resin insulation processing, oxide film formation, and the like, twisting six or more and 40 or less surface-treated NbTi superconducting multicore wires 1 and subjecting the twisted NbTi superconducting multicore wires to molding processing by biaxial roll rolling or the like.

Further, when the residual resistance ratio of the NbTi superconducting multicore wire 1 is set to 30 or more and 200 or less, low AC losses and current carrying stability can be ensured. As the superconducting characteristics of the NbTi superconducting multicore wire 1, given that coupling time constant under a changing magnetic field of ±3 T is 2.0 ms or less and critical current density Jc under a direct current (DC) magnetic field of 4.2 K and 5 T defined by a specific resistance of 10⁻¹⁴ Ωm per transverse cross sectional area of the NbTi superconducting multicore wire 1 is 2000 A /mm² or more and 3000 A /mm², the NbTi superconducting multicore wire can achieve both the low AC loss and the high current density characteristic.

According to the embodiment described above, by designing a plurality of NbTi filaments embedded in each of the NbTi filament assemblies constituting the filament assembly so as to be in a predetermined arrangement state, the production costs of the NbTi superconducting multicore wire can be reduced, and the NbTi superconducting multicore wire can exhibit a low AC loss and a high critical current.

While certain embodiments have been described above, the present invention is not limited to the embodiments, includes all embodiments encompassed in the scope of the claims, and can be variously modified within the scope of the disclosure.

### EXAMPLES

Next, the Examples and Comparative Examples will be explained, but the present disclosure is not limited to these Examples.

### (Example 1)

First, a Nb-47% by mass Ti rod wrapped with a Nb sheet was inserted into an oxygen-free copper tube to obtain a single core NbTi billet. Subsequently, the single core NbTi billet was subjected to hot extrusion, cold working and cutting to obtain nineteen oxygen-free copper-coated NbTi single core wires having a diameter of 31 mm.

Next, the oxygen-free copper-coated NbTi single core wires were inserted into each through hole of a Cu-10% by mass Ni tube having nineteen through holes to obtain a primary composite billet. In the transverse cross section of the primary composite billet, six oxygen-free copper-coated NbTi single core wires were arranged as the first layer in a circular shape around one oxygen-free copper-coated NbTi single core wire, and twelve oxygen-free copper-coated NbTi single core wires were arranged as the second layer in a circular shape around the circumference of an imaginary circle formed by the six oxygen-free copper-coated NbTi single core wires. Moreover, in the transverse cross section of the primary composite billet, the plurality of oxygen-free copper-coated NbTi single core wires were arranged in a rotationally symmetric manner about the one oxygen-free copper-coated NbTi single core wire by 15°. At this time, the twelve oxygen-free copper-coated NbTi single core wires constituting the second layer, which is the outermost circle, were arranged at equal intervals along the circumferential direction of the imaginary circle connecting the twelve oxygen-free copper-coated NbTi single core wires.

Next, the oxygen-free copper tube and the Cu-10% by mass Ni tube in the primary composite billet were integrated in a production process in which they were combined by extrusion, drawing and heat treatment to form a matrix. The content ratio of Ni contained in the matrix was 8% by mass. Subsequently, the combined primary composite billet was subjected to hot extrusion and cold working to obtain a hexagonal rod-shaped primary strand. The transverse cross section of the primary strand was hexagonal, and an opposite side dimension of the hexagonal shape was 3.5 mm.

Next, the oxygen-free copper billet and the Cu-10% by mass Ni billet were each subjected to hot extrusion and cold working to obtain a hexagonal rod-shaped oxygen-free copper wire and a CuNi wire. The transverse cross section of each of these was hexagonal and an opposite side dimension of the hexagonal shape was 3.5 mm.

Next, a plurality of (approximately 1300) primary strands, a plurality of oxygen-free copper wires, and a plurality of CuNi wires were inserted into an oxygen-free copper tube having an inner diameter of 175 mm and an outer diameter of 200 mm as the stabilizing layer to obtain a secondary composite billet. Subsequently, the secondary composite billet was subjected to hot extrusion, then a heat treatment and cold working were repeated, and twisting (pitch of 10 mm) and final drawing were performed to obtain a NbTi superconducting multicore wire as shown in FIGs. 1, 4, and 5 with a diameter of 1.0 mm (NbTi filament diameter of 3 um, matrix ratio of 3.5).

In the transverse cross section of the obtained NbTi superconducting multicore wire, a plurality of core portion stabilizing layers composed of a plurality of oxygen-free copper wires were embedded in a matrix composed of a plurality of CuNi wires at the core portion, and a plurality of core portion stabilizing layers were arranged in a circular shape around one core portion stabilizing layer. In the transverse cross section of the NbTi superconducting multicore wire, a first annular barrier layer and a second annular barrier layer composed of a plurality of CuNi wires were arranged inside and outside the filament assembly.

### (Example 2)

A NbTi superconducting multicore wire as shown in FIGs. 1 to 3 was obtained in the same manner as in Example 1, except that nineteen NbTi single core wires composed of only a Nb-47% by mass Ti rod were inserted into each of the through holes of a Cu-5% by mass Ni tube having nineteen through holes.

### (Example 3)

A NbTi superconducting multicore wire as shown in FIGs. 1 to 3 was obtained in the same manner as in Example 1, except that nineteen NbTi single core wires composed of only a Nb-47% by mass Ti rod were inserted into each of the through holes of a Cu-10% by mass Ni tube having nineteen through holes.

### (Comparative Example 1)

First, an oxygen-free tube was arranged inside a Cu-10% by mass Ni tube, and a Nb-47% by mass Ti rod wrapped with a Nb sheet was inserted into the oxygen-free tube, and hot extrusion, cold working and cutting were performed to obtain a hexagonal rod-shaped NbTi single core wire. The transverse cross section of the NbTi single core wire was hexagonal, and an opposite side dimension of the hexagonal shape was 17 mm. Subsequently, fifty five hexagonal rod-shaped NbTi single core wires were inserted into a Cu-10% by mass Ni tube to obtain a primary composite billet. At this time, the plurality of NbTi single core wires were assembled by a hexagonal closest packing method, and the plurality of NbTi single core wires were not concentrically arranged with respect to one NbTi single core wire as in Example 1.

Next, the oxygen-free copper tube and the Cu-10% by mass Ni tube in the primary composite billet were integrated in a production process in which they were combined by extrusion, drawing and heat treatment to form a matrix. The content ratio of Ni contained in the matrix was 8% by mass. Subsequently, the combined primary composite billet was subjected to hot extrusion and cold working to obtain a hexagonal rod-shaped primary strand. The transverse cross section of the primary strand was hexagonal, and an opposite side dimension of the hexagonal shape was 5.0 mm.

Next, the oxygen-free copper billet and the Cu-10% by mass Ni billet were each subjected to hot extrusion and cold working to obtain a hexagonal rod-shaped oxygen-free copper wire and a CuNi wire. The transverse cross section of each of these was hexagonal and an opposite side dimension of the hexagonal shape was 5.0 mm.

Next, a plurality of (approximately 450) primary strands, a plurality of oxygen-free copper wires, and a plurality of CuNi wires were inserted into an oxygen-free copper tube having an inner diameter of 175 mm and an outer diameter of 200 mm as the stabilizing layer to obtain a secondary composite billet. Subsequently, the secondary composite billet was subjected to hot extrusion, then a heat treatment and cold working were repeated, and twisting (pitch of 10 mm) and final drawing were performed to obtain a NbTi superconducting multicore wire with a diameter of 1.0 mm (NbTi filament diameter of 3 um, matrix ratio of 3.5).

In the transverse cross section of the obtained NbTi superconducting multicore wire, a plurality of NbTi filaments embedded in the filament assembly were in a state close to the hexagonal closest packing structure as a whole, unlike in Examples 1 to 3, and filaments in the outermost circle embedded in the NbTi filament assembly were randomly arranged. Further, in the transverse cross section of the NbTi superconducting multicore wire, a plurality of core portion stabilizing layers composed of a plurality of oxygen-free copper wires were embedded in a matrix composed of a plurality of CuNi wires at the core portion, and a plurality of core portion stabilizing layers were arranged in a circular shape around one core portion stabilizing layer. Further, in the transverse cross section of the NbTi superconducting multicore wire, a first annular barrier layer and a second annular barrier layer composed of a plurality of CuNi wires were arranged inside and outside the filament assembly.

### (Comparative Example 2)

A NbTi superconducting multicore wire was obtained in the same manner as in Comparative Example 1, except that the Nb-47% by mass Ti rod was subjected to hot extrusion, cold working and cutting to obtain a hexagonal rod-shaped NbTi single core wire, and fifty five NbTi single core wires were inserted into a Cu-10% by mass Ni tube. In the transverse cross section of the obtained NbTi superconducting multicore wire, a plurality of NbTi filaments embedded in the filament assembly were in a state close to the hexagonal closest packing structure as a whole, and filaments in the outermost circle embedded in the NbTi filament assembly were randomly arranged, similarly to Comparative Example 1.

### [Measurements and Evaluations]

The NbTi superconducting multicore wires obtained in the above Examples and Comparative Examples were measured and evaluated as follows. The results are shown in Table 1.

### [1] X_{Ni}A, X_{Mn}A, X_{Ni}B and X_{Mn}B

In a NbTi superconducting multicore wire, the Ni content ratio X_{Ni}A in the second copper alloy constituting the matrix of the filament assembly, the Mn content ratio X_{Mn}A in the second copper alloy constituting the matrix of the filament assembly, the Ni content ratio X_{Ni}B in the first copper alloy constituting the first barrier layer and the second barrier layer, and the Mn content ratio X_{Mn}B in the first copper alloy constituting the first barrier layer and the second barrier layer were measured by an electron probe microanalyzer (EPMA). These values were used to calculate (X_{Ni}A + X_{Mn}A) and (X_{Ni}B + X_{Mn}B).

### [1] Critical Current Density Jc

Critical current density Jc of the NbTi superconducting multicore wire was calculated from a calculation formula of (critical current Ic /transverse cross sectional area of the NbTi superconducting multicore wire). The critical current Ic was measured under a DC magnetic field of 4.2 K and 5 T.

### [2] n value

A n value of the NbTi superconducting multicore wire was obtained from current-voltage characteristics. The n value is defined as V = K (I/Ic)ⁿ, 10 µV /m to 100 µV /m, where V is generation voltage, I is conduction current, and K is a constant.

### [3] AC Loss

An AC loss of the NbTi superconducting multicore wire per cycle was measured by applying a changing magnetic field having a sine waveform with a magnetic field amplitude of ±3 T at 4.2 K while changing the frequency in a direction perpendicular to the longitudinal direction of the strand, followed by integration of an area from each of magnetization-applied magnetic field curves.

### [4] Coupling Time Constant (Separation of Hysteresis Loss and Coupling Loss)

From the frequency dependency of the AC loss, a value obtained by extrapolating to a frequency of 0 Hz was taken as the hysteresis loss, a component changed depending on the frequency was taken as the coupling loss, and a coupling time constant of the NbTi superconducting multicore wire was calculated from a slope thereof.

### [5] Processability (Wire Breaking Frequency)

For processability, the frequency of wire breaking per 20 km of a NbTi superconducting multicore wire was observed.

### [6] Current Carrying Stability

For current carrying stability, as a judgment as to whether or not practical current carrying stability is ensured, it was observed whether or not carrying a current was performed without quenching in a static magnetic field of 5 T. The current carrying stability is ranked as follows.
∘: Carrying a current was performed without quenching in a static magnetic field of 5 T.
×: Carrying a current was not performed without quenching in a static magnetic field of 5 T.

### [7] Production Cost

With reference to Comparative Example 1 to which the prior art was applied, the total amount of a raw material cost and a processing cost was relatively compared. The production cost is ranked as follows.
∘: The total amount of the raw material cost and the processing cost was reduced as compared to Comparative Example 1.
×: The total amount of the raw material cost and the processing cost was equal or increased as compared to Comparative Example 1.

### [8] Comprehensive Evaluation

With reference to Comparative Example 1 to which the prior art was applied, the evaluation was comprehensively performed based on whether or not the critical current density, the n value, and the current carrying stability were equivalent or higher; the low AC loss and the low coupling time constant were ensured; the wire breaking frequency was low; and the production cost was reduced. The comprehensive evaluation is ranked as follows.
⊙: It was superior to Comparative Example 1.
∘: It was better than Comparative Example 1.
×: It was inferior to Comparative Example 1.

**[Table 1]**

| | Example 1 | Example 2 | Example 3 | Comparative Example 1 | Comparative Example 2 |
|---|---|---|---|---|---|
| Arrangement state of NbTi filaments | · Concentric circle shape | | | · Not in concentric circle shape | |
| | · Equal intervals along the circumferential direction | | | · Not equal intervals along the circumferential direction | |
| | · Rotationally symmetric | | | | |
| | | | | · Not rotationally symmetric | |
| Ni content ratio in the matrix of the filament assembly (% by mass) X_{Ni}A | 8.0 | 5.0 | 10.0 | 8.0 | 10.0 |
| Mn content ratio in the matrix of the filament assembly (% by mass) X_{Mn}A | 0.4 | 0.5 | 0.5 | 0.4 | 0.5 |
| Ni content ratio in the first and second barrier layers (% by mass) X_{Ni}B | 10.0 | 10.0 | 10.0 | 10.0 | 10.0 |
| Mn content ratio in the first and second barrier layers (% by mass) X_{Mn}B | 0.5 | 0.5 | 0.5 | 0.5 | 0.5 |
| X_{Ni}A + X_{Mn}A | 8.4 | 5.5 | 10.5 | 8.4 | 10.5 |
| X_{Ni}B + X_{Mn}B | 10.5 | 10.5 | 10.5 | 10.5 | 10.5 |
| Critical current density Jc (A/mm²) | 2400 | 2300 | 2200 | 2200 | 2100 |
| n value | 35 | 35 | 30 | 30 | 25 |
| AC loss (kJ/m³) | 16 | 16 | 17 | 19 | 21 |
| Coupling time constant (ms) | 0.5 | 0.6 | 0.4 | 0.6 | 0.5 |
| Processability (frequency of wire breaking) | 0 | 0 | 0 | 1 | 2 |
| Current carrying stability | ○ | ○ | ○ | ○ | ○ |
| Production cost | ○ | ○ | ○ | - | × |
| Comprehensive evaluation | ⊚ | ○ | ○ | - | × |

As shown in Table 1, Example 1 was excellent in the current carrying characteristics (Jc and n value) and had a sufficiently low AC loss characteristic. Example 2 showed the same AC loss characteristic as that of Example 1, and the current carrying characteristic was the second best to Example 1. The current carrying characteristic and AC loss characteristic of Example 3 were good. Further, in none of Examples 1 to 3, wire breaking occurred. In Example 1 in which the current carrying characteristic and the AC loss characteristic were the best, the reduction in the total amount of the raw material cost and the processing cost by about 10% compared to the Comparative Example 1 could be achieved.

On the other hand, in Comparative Examples 1 and 2, the current carrying characteristics were reduced and the AC loss characteristics were deteriorated as compared with Examples 1 to 3. Further, in Comparative Examples 1 and 2, wire breaking occurred.

As described above, the superconducting performance of the NbTi superconducting multicore wires of Examples 1 to 3 was higher in Jc and the n value than those of Comparative Examples 1 to 2, the AC loss could be reduced, the wire drawing workability was excellent, and reduction in the production cost was achieved.

Examples 1 to 3 in which the Ni concentrations were changed are indicated above, the same effect as in Examples 1 to 3 can be obtained also in examples in which the Mn concentrations are changed.
1 NbTi superconducting multicore wire
10 Core portion
11 Matrix (core portion matrix)
12 Core portion stabilizing layer
20 First barrier layer
30 Filament assembly
31 NbTi filament assembly
32 Matrix
33 NbTi filament
33c Central filament
33m Inner filament
33o Outermost layer filament
34 Stabilizing Cu layer
40 Second barrier layer
50 Stabilizing Layer

## Claims

1. A NbTi superconducting multicore wire, comprising:
a core portion;
a first barrier layer arranged around the circumference of the core portion and composed of a first copper alloy including at least one element selected from Ni or Mn;
a filament assembly arranged around the circumference of the first barrier layer and including a plurality of NbTi filament assemblies each including a plurality of NbTi filaments, the plurality of NbTi filaments being at least seven NbTi filaments, embedded in a matrix composed of a second copper alloy including at least one element selected from Ni or Mn;
a second barrier layer arranged around the circumference of the filament assembly and composed of the first copper alloy; and
a stabilizing layer arranged around the circumference of the second barrier layer and composed of a metal,
in a transverse cross section perpendicular to a longer direction, the plurality of NbTi filaments in each of the NbTi filament assemblies being arranged in one or more circular shapes each having a different diameter, centering on one NbTi filament; and a plurality of NbTi filaments arranged in a circular shape in an outermost circle being arranged at approximately equal intervals along a circumferential direction.

2. The NbTi superconducting multicore wire according to claim 1, wherein a total ratio A (X_{Ni}A + X_{Mn}A), which is a sum of a Ni content ratio X_{Ni}A and a Mn content ratio X_{Mn}A in the second copper alloy constituting the matrix of the filament assembly, is smaller than a total ratio B (X_{Ni}B + X_{Mn}B), which is a sum of a Ni content ratio X_{Ni}B and a Mn content ratio X_{Mn}B in the first copper alloy constituting the first barrier layer and the second barrier layer.

3. The NbTi superconducting multicore wire according to claim 1 or 2,
wherein, in the transverse cross section,
the plurality of NbTi filaments in each of the NbTi filament assemblies are arranged in two or more circular shapes each having a different diameter, centering on one NbTi filament, and
the plurality of NbTi filaments arranged in a circular shape in the outermost circle are arranged so as to rotate by approximately (180/n)° centering on the one NbTi filament arranged at the center, relative to a base line L,
the base line L connecting:
a center of a NbTi filament among a plurality of NbTi filaments which are internally adjacent with the plurality of NbTi filaments arranged in a circular shape in the outermost circle, and which are arranged in a circular shape; and a center of the one NbTi filament arranged at the center.

4. The NbTi superconducting multicore wire according to any one of claims 1 to 3, wherein the core portion comprises a matrix composed of the first copper alloy.

5. The NbTi superconducting multicore wire according to any one of claims 1 to 4, wherein the Ni content ratio X_{Ni}B in the first copper alloy constituting the first barrier layer and the second barrier layer is 5.0% by mass or more and 30.0% by mass or less, and the Ni content ratio X_{Ni}A in the second copper alloy constituting the matrix of the filament assembly is 0.1X_{Ni}B or more and 0.9X_{Ni}B or less.

6. The NbTi superconducting multicore wire according to any one of claims 1 to 5, wherein the Mn content ratio X_{Mn}B in the first copper alloy constituting the first barrier layer and the second barrier layer is 0.1% by mass or more and 2.0% by mass or less, and the Mn content ratio X_{Mn}A in the second copper alloy constituting the matrix of the filament assembly is 0.3X_{Mn}B or more and 0.9X_{Mn}B or less.

7. The NbTi superconducting multicore wire according to any one of claims 1 to 6,
wherein, in the transverse cross section,
a ratio (cross sectional area of the matrix/total cross sectional area of the plurality of NbTi filaments) of a cross sectional area of the matrix in the filament assembly with respect to a total cross sectional area of the plurality of NbTi filaments is 0.2 or more and 2.0 or less, and
a ratio {(cross sectional area of the matrix + cross sectional area of the first barrier layer + cross sectional area of the second barrier layer + cross sectional area of the matrix in the core portion + cross sectional area of the stabilizing layer) / total cross sectional area of the plurality of NbTi filaments} of a total of cross sectional areas of the matrix in the filament assembly, the first barrier layer, the second barrier layer, the matrix in the core portion, and the stabilizing layer with respect to a total of cross sectional area of the plurality of NbTi filaments is 2.0 or more and 6.0 or less.
